# EUROPEAN PATENT SPECIFICATION

(11) **EP 1 355 354 B1**
(45) Date of publication and mention of the grant of the patent: **02.01.2008**
(21) Application number: 02008667.4
(22) Date of filing: 17.04.2002
(51) Int. Cl.: H01L 27/02, H01L 27/06

(54) **Power MOSFET with ESD protection**
Leistungs-MOSFET mit Schutz gegen ESD
MOSFET de puissance avec une protection contre les ESD

(43) Date of publication of application: 22.10.2003
(73) Proprietor: Bankuti Vilmos, New Bedford, MA 02740 (US)
(72) Inventor: Bankuti Vilmos, New Bedford, MA 02740 (US)
(74) Representative: Schäfer, Matthias W.

(56) References cited:
- EP-A- 0 372 820
- DE-A- 4 236 334
- US-A- 4 962 411
- US-A- 5 087 955
- PATENT ABSTRACTS OF JAPAN vol. 1996, no. 02, 29 February 1996 (1996-02-29) -& JP 07 271459 A (AIPHONE CO LTD), 20 October 1995 (1995-10-20)

## Description

The present invention relates to an improved metal oxide semiconductor field effect transistor (MOSFET) which is electrically protected against electrostatic build up and discharge.

In the past, several schemes have been used to protect MOSFETs from potentially destructive voltages and currents. These measures include grounding of the electronic circuit boards on which these MOSFETs are to be embedded and grounding of the handling personal, anti-static packaging for transport, etc. So far, no inexpensive and still effective solution has been found that can eliminate the handling, packaging and assembly precautions currently needed in medium to high power MOSFET applications to properly safeguard against damage due to electrostatic build up and discharge. Moreover, all these known protective measures are external and are added from the outside to the MOSFET packaging.

Attempts to improve this situation utilizing clamping devices like back-to-back Zener diods are numerous. Two examples are disclosed in JP 61296770 A and US 5,528,064. The so-called clamping circuits, as disclosed in US 5,528,064, limit the voltage stored at the gate-source capacitance. These clamping devices do not provide a discharge path for electric charges at the gate-source capacitance. Clamping devices simply prevent the stored voltage from going above a predetermined value. Clamping devices allow charge to accumulate and thus do not prevent electrostatic discharge (ESD) damage if, for example, the gate and source nodes of the device are inadvertently shorted. The present invention continuously discharges the gate-source capacitance to prevent device damage even when the gate and source nodes are shorted.

Therefore, the technical objective of the present invention is to provide a MOSFET which avoids the drawbacks of the cited prior art, which is electrostatically protected and in turn more reliable. In this connection it is an object to eliminate the need for electrostatic handling and packaging precautions as well as to protect the MOSFET during assembly, e.g. in case of short circuits occurring during mounting such MOSFETS on an electronic circuit. It is further an object to provide a solution which reduces the costs for such protection efficiently.

The above problem has been solved by an improved MOSFET having the features of claim 1 and the use of a resistance for ESD protection according to claim 6. Preferred embodiments of the invention are described in the dependent claims.

According to the present invention an electrically protected metal oxide semiconductor field effect transistor (MOSFET) package having a gate node, a source node and a drain node, is characterized in that it incorporates within the package a resistance connected between the gate node and the source node. Thus, the present invention is defined by exclusively adding a resistance connected between the gate node and the source node of a MOSFET device. This resistance provides a continuous discharge path for electric charges that are accumulated on a gate-source capacitance. By continuously discharging this capacitance, there is no voltage build up and thus little likelihood of destruction of the MOSFET device due to electrostatic discharge. In order to achieve the inventive solution, in the MOSFET a protection resistive element is formed in or on the semiconductor layer, e.g. a polycrystalline silicon layer or implemented as a thin film or thick film or hybrid resistor on the silicon substrate. The improved MOSFET according to the present invention contains a surprisingly simple design which nevertheless protects efficiently the MOSFET against electrostatic build up and discharge. It further is easy to incorporate in the chip manufacturing process.

Hence, the improved MOSFET according to the present invention is electrically protected against electrostatic build up and discharge and in turn more reliable. The need for electrostatic handling and packaging precautions as well as to protect the MOSFET during assembly is eliminated. The costs for such protection are efficiently reduced.

A preferred embodiment of the present invention is characterized in that the resistance is an integrated resistor. The resistor can be implemented as part of the monolithic process during the fabrication of the MOSFET itself. Alternatively, it can be implemented through thin film technology, thick film technology and in case of a chip resistor, hybrid technology.

A further advantageous embodiment is characterized in that the resistor has a first terminal and a second terminal, the first terminal being connected directly to the gate node and the second terminal being connected directly to the source node.

Still another preferred embodiment of the present invention is characterized in that the resistor has an impedance in the range of 1 kΩ to 10 kΩ, preferably 5 kΩ. The given range was found to be large enough to not seriously affect the gate drive applied and small enough to provide protection. With 5 kΩ the best compromise was found between loss due to the resistor impedance and still providing enough protection for the MOSFET device.

Another preferred embodiment of the present invention is characterized in that the resistor is made of polycrystalline silicon or any other suitable material. Of course the resistor material can vary depending on the production process.

Yet another preferred embodiment of the present invention is characterized in that the resistance provides continuous discharge of voltage accumulated on the gate-source capacitance. This is very important by preventing electrostatic build up on the input gate-source capacitance thus eliminating the possibility of an ESD (electrostatic discharge) occurrence by accidental shorting the gate node to the source node.

Another preferred embodiment of the present invention is characterized in that the MOSFET device is a power MOSFET device. In this application the gate drive loss due to the loading effect of the integrated protection resistance is neglectable. The extremely high input resistance of the MOSFET itself is effectively reduced. The high input resistance is utilized mainly in low power, small signal applications. In power MOSFET applications however, the high input resistance is not needed.

Another preferred embodiment provides a plurality of MOSFET devices in the same package which are protected against electrostatic charge by a protective device according to the present invention. In this case, the term "the same package" defines the MOSFET and the protective device being implemented on the same substrate.

The modified MOSFET according to the present invention will save the electronics industry millions of dollars every year. Savings would be seen through the elimination of present training and equipment needed to provide ESD prevention.

Following, the present invention will be described more clearly in connection with a preferred embodiment. Thereby, reference is made to the attached drawing:

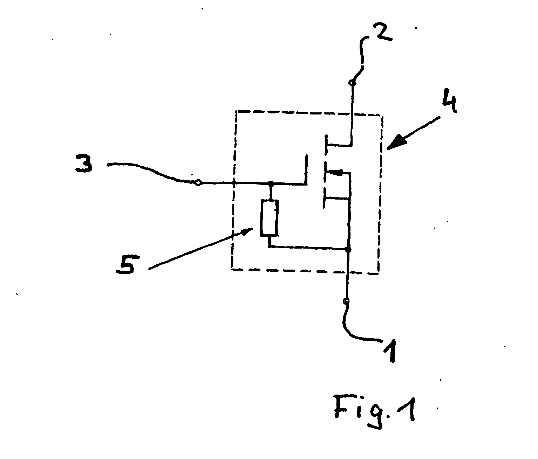

- Figure 1: shows a circuit diagram representing an N-Channel, enhancement mode MOSFET with the integrated Electrostatic Protective Resistor within the MOSFET package.

Figure 1 illustrates a typical application with a power MOSFET device. The integrated Electrostatic Protective Resistor 5 is electrically connected to the gate 3 and source 1 nodes of the metal oxide semiconductor field effect transistor (MOSFET) within the MOSFET package 4. In the present embodiment the resistor is implemented as part of the monolithic process during the fabrication of the MOSFET itself. The impedance of the resistor is in this embodiment 5 kΩ.

Both N-channel and P-channel MOSFET devices exhibit very large resistances between their gate and source nodes being in excess of up to 1000 Mega Ohm (MΩ).

This resistance is referred to as the gate-source static resistance or the static input resistance of the MOSFET. The metal oxide insulation between the gate and source for practical devices is very thin, therefore it has only a very low dielectric strength which is typically in the range of +/- 20 VDC. The gate, the source and the metal oxide insulation between them, form a capacitance, which is called the gate-source capacitance. This capacitor can reach a value up to several thousand pico Farads (pF).

Electrostatic build up in general, can charge up any capacitor with high insulation resistance to a very high DC voltage, in some cases up to thousands of volts. If the gate 3 and source 1 electrodes of the MOSFET are not connected to an external circuit capable of limiting the electrostatic build up, the subsequent charge can create a DC voltage that can exceed the dielectric strength of the metal oxide layer. In turn, dielectric breakdown occurs leading to a discharge through the dielectric material. The discharge current can momentarily generate local temperatures high enough to permanently damage the metal oxide layer, rendering the MOSFET inoperative. This is effectively avoided by the electrical protection according to the present invention. Notice, that for clarity, figure 1 does not show the gate-source static resistance, or the gate-source capacitance. Figure 1 only shows the integrated electrostatic protective resistor.

### Reference Numerals

- 1: Source Node
- 2: Drain Node
- 3: Gate Node
- 4: MOSFET Package
- 5: Integrated Electrostatic Protective Resistor

## Claims

1. An improved metal oxide semiconductor field effect transistor (MOSFET) having a gate node (3), a source node (1) and a drain node (2), wherein the MOSFET (4) further comprises an electrical input protection against electrostatic build up and discharge,
**characterized in that**
the electrical input protection against electrostatic build up and discharge consists of a resistance (5) being implemented in the MOSFET (4) and being connected between the gate node (3) and the source node (1).

2. An improved MOSFET according to claim 1,
**characterized in that**
the resistance (5) has an impedance in the range of 1 kΩ to 10 kΩ, preferably 5 kΩ.

3. An improved MOSFET according to claim 1 or 2,
**characterized in that**
the resistance is an integrated resistor element (5).

4. An improved MOSFET according to claim 3,
**characterized in that**
the resistor element (5) has a first terminal and a second terminal, the first terminal being connected directly to the gate node (3) and the second terminal being connected directly to the source node (1).

5. An improved MOSFET according to one of the precedent claims,
**characterized in that**
the resistor element (5) is made of polycrystalline silicon or any other suitable material.

6. An improved MOSFET according to one of the precedent claims,
**characterized in that**
the MOSFET (4) is a power MOSFET device.

7. Use of a resistance (5) as an electrical input protection against electrostatic build up and discharge (ESD protection) for a metal oxide semiconductor field effect transistor (MOSFET) having a gate node (3), a source node (1) and a drain node (2), the resistance (5) being implemented in the MOSFET (4) and being connected between the gate node (3) and the source node (1).

8. Use of a resistance according to claim 7, wherein the resistance (5) provides continuous discharge path against electrostatic charge accumulation and subsequent potentially destructive voltage build-up on the gate node (3).

9. Use of a resistance according to claim 7, wherein the resistance (5) has an impedance in the range of 1 kΩ to 10 kΩ, preferably 5 kΩ.

## Patentansprüche

1. Verbesserter Metalloxid-Halbleiter-Feldeffekttransistor (MOSFET), mit einem Gate-Knoten (3), einem Source-Knoten (1) und einem Drain-Knoten (2), in dem der MOSFET (4) einen elektrischen Eingangsschutz gegen elektrostatische Auf- und Entladung aufweist,
**dadurch gekennzeichnet, dass**
der elektrische Eingangsschutz gegen elektrostatische Auf- und Entladung aus einem Widerstand (5) besteht, der im MOSFET (4) implementiert und zwischen dem Gate-Knoten (3) und dem Source-Knoten (1) angeschlossen ist.

2. Verbesserter MOSFET gemäß Patentanspruch 1,
**dadurch gekennzeichnet, dass**
der Widerstand (5) eine Impedanz im Bereich 1 kΩ bis 10 kΩ, vorzugsweise 5 kΩ hat.

3. Verbesserter MOSFET gemäß Patentanspruch 1 oder 2,
**dadurch gekennzeichnet, dass**
der Widerstand von einem integrierten Widerstandselement (5) gebildet ist.

4. Verbesserter MOSFET gemäß Patentanspruch 3,
**dadurch gekennzeichnet, dass**
das Widerstandselement (5) einen ersten Anschluss und einen zweiten Anschluss hat, wobei der erste Anschluss direkt mit dem Gate-Knoten (3) verbunden ist, und der zweite Anschluss direkt mit dem Source-Knoten (1) verbunden ist.

5. Verbesserter MOSFET gemäß einem der vorangehenden Patentansprüche,
**dadurch gekennzeichnet, dass**
das Widerstandselement (5) aus polykristallinem Silizium oder irgendeinem anderen geeigneten Material gefertigt ist.

6. Verbesserter MOSFET gemäß einem der vorangehenden Patentansprüche,
**dadurch gekennzeichnet, dass**
der MOSFET (4) ein Leistungs-MOSFET ist.

7. Verwendung eines Widerstands (5) als ein elektrischer Eingangsschutz gegen elektrostatische Auf- und Entladung (ESD-Schutz) für einen Metalloxid-Halbleiter-Feldeffekttransistor (MOSFET), der einen Gate-Knoten (3), einen Source-Knoten (1) und einen Drain-Knoten (2) aufweist, wobei der Widerstand (5) in den MOSFET (4) implementiert ist und zwischen Gate-Knoten (3) und Source-Knoten (1) angeschlossen ist.

8. Verwendung eines Widerstands gemäß Patentanspruch 7, wobei der Widerstand (5) einen kontinuierlichen Entladungspfad gegen eine Ansammlung elektrostatischer Ladung und nachfolgenden potenziell zerstörerischen Spannungsaufbau am Gate-Knoten (3) bereitstellt.

9. Verwendung eines Widerstands gemäß Patentanspruch 7, wobei der Widerstand (5) eine Impedanz im Bereich von 1 kΩ bis 10 kΩ, vorzugsweise 5 kΩ ist.

## Revendications

1. Un MOSFET amélioré (transistor à effet de champ à semi-conducteur métal oxyde) présentant une borne grille (3), une borne source (1) et une borne drain (2), le MOSFET (4) comprenant en outre une protection d'entrée électrique contre l'accumulation et la décharge d'électricité statique,
**caractérisé en ce que** la protection de l'entrée contre l'accumulation et la décharge d'électricité statique consiste en une résistance (5) placée dans le MOSFET (4) et branchée entre la borne grille (3) et la borne source (1).

2. Un MOSFET amélioré selon la revendication 1
**caractérisé en ce que**
la résistance (5) présente une impédance de 1kΩ à 10kΩ, de préférence 5kΩ.

3. Un MOSFET amélioré selon la revendication 1 ou 2
**caractérisé en ce que**
la résistance est un élément de résistance intégré (5).

4. Un MOSFET amélioré selon la revendication 3
**caractérisé en ce que**
l'élément de résistance (5) présente un premier terminal et un second terminal, le premier terminal étant relié directement à la borne grille (3) et le second terminal étant relié directement à la borne source (1).

5. Un MOSFET amélioré selon une des revendications précédentes
**caractérisé en ce que**
l'élément de résistance (5) se compose de silicium polycristallin ou autre matériau adapté.

6. Un MOSFET amélioré selon une des revendications précédentes
**caractérisé en ce que**
le MOSFET (4) est un MOSFET de puissance.

7. Utilisation d'une résistance (5) en tant que protection d'entrée électrique contre l'accumulation et la décharge d'électricité statique (protection ESD) pour un MOSFET (transistor à effet de champ à semi-conducteur métal-oxyde) présentant une borne grille (3), une borne source (1) et une borne drain (2), la résistance étant placée dans le MOSFET (4) et branchée entre la borne grille (3) et la borne source (1).

8. Utilisation d'une résistance selon la revendication 7 où la résistance (5) fournit un chemin de décharge contre l'accumulation d'électricité statique et une accumulation de tension potentiellement destructive sur la borne grille (3).

9. Utilisation d'une résistance selon la revendication 7 où la résistance (5) présente une impédance de 1kΩ à 10kΩ, de préférence 5kΩ.
